# EUROPEAN PATENT APPLICATION

(11) **EP 4 839 051 A1**
(43) Date of publication of application: **11.11.2026**
(21) Application number: 25760803.4
(22) Date of filing: 18.02.2025
(51) Int. Cl.: H10F 19/00

(54) **BUSBAR-FREE BACK-CONTACT CELL ASSEMBLY AND PREPARATION METHOD THEREFOR**

(30) Priority: 26.02.2024 CN 202410211574
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: XU, Zhigang, Jinhua, Zhejiang 322000 (CN); WANG, Yongqian, Jinhua, Zhejiang 322000 (CN); CHEN, Gang, Jinhua, Zhejiang 322000 (CN)
(74) Representative: EP&C
(86) International application number: PCT/CN2025/077912
(87) International publication number: WO 2025/180261

(57) **Abstract**

The present disclosure is applicable to the technical field of solar cells, and provides a busbar-free back contact cell assembly and preparation methods therefor. **In** the busbar-free back contact cell assembly, a busbar-free cell string is composed of busbar-free back contact cells, and positive solder ribbons and negative solder ribbons are fixed on the busbar-free back contact cells by pre-fixed film layers. **In** this way, no busbar lines need to be provided on back surfaces of the busbar-free back contact cells, and there is no need to print a pad on the busbar, which can reduce the use of silver paste and reduce costs. Moreover, after the positive solder ribbons and the negative solder ribbons are laid, the positive solder ribbons and the negative solder ribbons are fixed on the back surfaces of the busbar-free back contact cells by using the pre-fixed film layers; and a flowability of the pre-fixed film layers in an initial lamination process is lower than a flowability of a second adhesive film in the initial lamination process, which can effectively avoid deviation of the positive solder ribbons and the negative solder ribbons in the process of manufacturing said assembly, and can improve the positioning and alignment precision of the positive solder ribbons and the negative solder ribbons.

## Description

### Technical Field

The present disclosure relates to the technical field of solar cells, and in particular, to a busbar-free back contact cell assembly and preparation methods therefor.

### Background

Currently, in the photovoltaic industry, most back contact photovoltaic assemblies are MBB, in which a high-temperature infrared soldering method is used, that is, a pad is printed on a busbar of a cell sheet, a solder paste is printed on the pad, an insulating adhesive is printed on fine grid lines having opposite polarities near the busbar, the printed solder paste and insulating adhesive are dried or cured, and treated cell sheets form one string, solder ribbons are covered above a busbar line, pressing is performed, and then infrared soldering is performed.

However, in such a technical solution, more silver paste needs to be used in the process of manufacturing the busbar and the pad of the cell sheet, leading to a very high cost; in addition, due to the existence of the solder paste during placement of the solder ribbons, yield problems such as deviation of solder ribbons may occur in the placement of the solder ribbons.

### Summary

Some embodiments of the present disclosure provide a busbar-free back contact cell assembly and preparation methods therefor, which are intended to solve the technical problems of low yield, high costs, and easy occurrence of deviation of solder ribbons in the process of manufacturing the cell assembly in the related art.

Some embodiments of the present disclosure are implemented as follows: the busbar-free back contact cell assembly according to embodiments of the present disclosure includes a first cover plate, a first adhesive film, at least one busbar-free cell string, a second adhesive film and a second cover plate which are stacked in sequence; wherein the busbar-free cell string includes:
several busbar-free back contact cells, wherein back surfaces of the busbar-free back contact cells are provided with several positive fine grids and several negative fine grids, and the several positive fine grids and the several negative fine grids are arranged alternately at intervals in sequence;
several positive solder ribbons and several negative solder ribbons, wherein the positive solder ribbons intersect with the positive fine grids and are in conductive connection with the positive fine grids, and the negative solder ribbons intersect with the negative fine grids and are in conductive connection with the negative fine grids; and
pre-fixed film layers, which are provided on the positive solder ribbons and the negative solder ribbons, wherein the pre-fixed film layers are fixedly connected to the back surfaces, so as to fix the positive solder ribbons and the negative solder ribbons on the back surfaces;
wherein the second adhesive film is covered on the pre-fixed film layers, and a flowability of the pre-fixed film layers in an initial lamination process is lower than a flowability of the second adhesive film in the initial lamination process.

In some embodiments, a gram weight of the pre-fixed film layers per square meter is 50 g-200 g.

In some embodiments, first solder layers are provided at positions on the positive fine grids in contact with the positive solder ribbons, and the positive solder ribbons are connected to the first solder layers; and second solder layers are provided at positions on the negative fine grids in contact with the negative solder ribbons, and the negative solder ribbons are connected to the second solder layers.

In some embodiments, both the first solder layers and the second solder layers are made of a solder paste.

In some embodiments, the positive solder ribbons completely cover the first solder layers, and the negative solder ribbons completely cover the second solder layers.

In some embodiments, first insulating layers are provided at positions on the positive fine grids intersecting with the negative solder ribbons, and the negative solder ribbons are insulated and isolated from the positive fine grids by the first insulating layers; and
second insulating layers are provided at positions on the negative fine grids intersecting with the positive solder ribbons, and the positive solder ribbons are insulated and isolated from the positive fine grids by the second insulating layers.

In some embodiments, the positive fine grids are disconnected at positions intersecting with the negative solder ribbons, and the negative fine grids are disconnected at positions intersecting with the positive solder ribbons.

In some embodiments, the pre-fixed film layers include at least one of a PVB adhesive film, an EVA adhesive film, an EPE adhesive film, an EP adhesive film and a POE adhesive film, and the second adhesive film includes at least one of a POE adhesive film, an EVA adhesive film, an EPE adhesive film, an EP adhesive film, a PE adhesive film and a PVB adhesive film.

In some embodiments, two adjacent busbar-free back contact cells are arranged at an interval;
wherein the pre-fixed film layers cover the busbar-free back contact cells; or
the pre-fixed film layers cover both the busbar-free back contact cells and a gap between the two adjacent busbar-free back contact cells; or
the pre-fixed film layers at least cover the positive solder ribbons and the negative solder ribbons.

In some embodiments, the several positive solder ribbons include several first positive solder ribbons and several second positive solder ribbons, the pre-fixed film layers are provided on the first positive solder ribbons to fix the first positive solder ribbons on the back surfaces, and the second positive solder ribbons are fixed on the back surfaces by a first dispensing adhesive.

In some embodiments, the several negative solder ribbons include first negative solder ribbons and second negative solder ribbons, the pre-fixed film layers are provided on the first negative solder ribbons to fix the first negative solder ribbons on the back surfaces, and the second negative solder ribbons are fixed on the back surfaces by a second dispensing adhesive.

Some embodiments of the present disclosure further provide a preparation method for a busbar-free back contact cell assembly, the preparation method including:
several busbar-free back contact cells are provided, wherein back surfaces of the busbar-free back contact cells are provided with several positive fine grids and several negative fine grids, and the several positive fine grids and the several negative fine grids are arranged alternately at intervals in sequence;
several positive solder ribbons and several negative solder ribbons are laid on the busbar-free back contact cells, wherein the positive solder ribbons intersect with the positive fine grids and are in conductive connection with the positive fine grids, and the negative solder ribbons intersect with the negative fine grids and are in conductive connection with the negative fine grids;
pre-fixed film layers are laid on the several busbar-free back contact cells, and the pre-fixed film layers are slightly molten and then cured to be adhered with the back surfaces of the busbar-free back contact cells, so as to fix the positive solder ribbons and the negative solder ribbons, thereby forming a busbar-free cell string;
the busbar-free cell string is laid on a first cover plate on which a first adhesive film is placed, wherein the back surfaces of the busbar-free back contact cells face away from the first adhesive film;
a second adhesive film and a second cover plate are laid on a back surface of the busbar-free back contact cell string; and
a lamination and soldering treatment is performed to form the busbar-free back contact cell assembly, wherein a flowability of the pre-fixed film layers in an initial lamination process is lower than a flowability of the second adhesive film in the initial lamination process.

In some embodiments, the pre-fixed film layers are laid on the several busbar-free back contact cells, and the pre-fixed film layers are slightly molten and adhered with the back surfaces of the busbar-free back contact cells, so as to fix the positive solder ribbons and the negative solder ribbons, includes:
the pre-fixed film layers are adsorbed by adsorption pressing blocks, the pre-fixed film layers are placed on the busbar-free back contact cells and heated, and in the heating process, a pressure is applied to the pre-fixed film layers by the adsorption pressing blocks, such that the pre-fixed film layers are slightly molten and then cured and thus are adhered with the back surfaces, thereby fixing the positive solder ribbons and the negative solder ribbons.

In some embodiments, when the pre-fixed film layers are laid, a temperature is maintained in a temperature range of 50°C-150°C, such that the pre-fixed film layers are slightly molten and then cured so as to be adhered with the back surfaces of the busbar-free back contact cells.

In some embodiments, before the several positive solder ribbons and the several negative solder ribbons are laid on the busbar-free back contact cells, the preparation method further includes:
first solder layers are prepared at positions on the positive fine grids in contact with the positive solder ribbons, and second solder layers are prepared at positions on the negative fine grids in contact with the negative solder ribbons; and
the several positive solder ribbons and the several negative solder ribbons are laid on the busbar-free back contact cells, includes:
   the positive solder ribbons are laid at positions of the first solder layers, and the negative solder ribbons are laid at positions of the second solder layers.

In some embodiments, the first solder layers and the second solder layers are both formed by printing a solder paste and then drying and curing same, or are formed without drying and curing.

In some embodiments, before the several positive solder ribbons and the several negative solder ribbons are laid on the busbar-free back contact cells, the preparation method further includes:
first insulating layers are prepared at positions on the positive fine grids intersecting with the negative solder ribbons, and second insulating layers are prepared at positions on the negative fine grids intersecting with the positive solder ribbons.

Some embodiments of the present disclosure further provide another preparation method for a busbar-free back contact cell assembly, the preparation method including:
a first adhesive film is laid on a first cover plate;
several busbar-free back contact cells arranged at intervals are laid on the first adhesive film, wherein back surfaces of the busbar-free back contact cells are provided with several positive fine grids and several negative fine grids, and the several positive fine grids and the several negative fine grids are arranged alternately at intervals in sequence, and the back surfaces of the busbar-free back contact cells face away from the first adhesive film;
several positive solder ribbons and several negative solder ribbons are laid on the busbar-free back contact cells, wherein the positive solder ribbons intersect with the positive fine grids and are in conductive connection with the positive fine grids, and the negative solder ribbons intersect with the negative fine grids and are in conductive connection with the negative fine grids;
pre-fixed film layers are laid on the several busbar-free back contact cells, and the pre-fixed film layers are slightly molten and the cured so as to be adhered with the back surfaces of the busbar-free back contact cells, so as to fix the positive solder ribbons and the negative solder ribbons;
a second adhesive film and a second cover plate are laid on the pre-fixed film layers; and
a lamination and soldering treatment is performed to form the busbar-free back contact cell assembly, wherein a flowability of the pre-fixed film layers in an initial lamination process is lower than a flowability of the second adhesive film in the initial lamination process.

In some embodiments, the pre-fixed film layers are laid on the several busbar-free back contact cells, and the pre-fixed film layers are slightly molten and adhered with the back surfaces of the busbar-free back contact cells, so as to fix the positive solder ribbons and the negative solder ribbons, includes:
the pre-fixed film layers are adsorbed by adsorption pressing blocks, the pre-fixed film layers are placed on the busbar-free back contact cells and heated, and in the heating process, a pressure is applied to the pre-fixed film layers by the adsorption pressing blocks, such that the pre-fixed film layers are slightly molten and then cured and thus are adhered with the back surfaces, thereby fixing the positive solder ribbons and the negative solder ribbons.

In some embodiments, before the several positive solder ribbons and the several negative solder ribbons are laid on the busbar-free back contact cells, the preparation method further includes:
first solder layers are prepared at positions on the positive fine grids in contact with the positive solder ribbons, and second solder layers are prepared at positions on the negative fine grids in contact with the negative solder ribbons; and
the several positive solder ribbons and the several negative solder ribbons are laid on the busbar-free back contact cells, includes:
   the positive solder ribbons are laid at positions of the first solder layers, and the negative solder ribbons are laid at positions of the second solder layers.

In the busbar-free back contact cell assembly and the preparation methods therefor in the embodiments of the present disclosure, the busbar-free cell string is formed by the busbar-free back contact cells, the positive solder ribbons are in conductive connection with the positive fine grids, and the negative solder ribbons are in conductive connection with the negative solder ribbons, thereby achieving convergence and output of current. The positive solder ribbons and the negative solder ribbons are fixed on the busbar-free back contact cells by the pre-fixed film layers. In this way, no busbar lines need to be provided on the back surfaces of the busbar-free back contact cells, and there is no need to print a pad on the busbar, which can reduce the use of silver paste and reduce costs. Moreover, after the positive solder ribbons and the negative solder ribbons are laid, the positive solder ribbons and the negative solder ribbons are fixed on the back surfaces of the busbar-free back contact cells by using the pre-fixed film layers; and the flowability of the pre-fixed film layer in the initial lamination process is lower than the flowability of the second adhesive film in the initial lamination process. In this way, in the initial lamination process, the flowability of the pre-fixed film layers is lower, which can effectively prevent deviation of the positive solder ribbons and the negative solder ribbons in the process of manufacturing the busbar-free back contact cell assembly, which improves the positioning and alignment precision of the positive solder ribbons and the negative solder ribbons, thereby ensuring the yield. Moreover, compared with pre-fixing the negative solder ribbons and the positive solder ribbons by dispensing in the related art, fixing the negative solder ribbons and the positive solder ribbons by using the pre-fixed film layers can effectively avoid cold solder joints and avoid EL defects. That is to say, fixing the solder ribbons by dispensing tends to lead to cold solder joints and cause EL defects, and the technical solutions of some embodiments of the present disclosure can avoid these problems.

Additional aspects and advantages of some embodiments of the present disclosure will be given in part in the following description, become apparent in part from the following description, or be learned from the practice of some embodiments of the present disclosure.

### Brief Description of the Drawings

Fig. 1 is a schematic diagram of modules of a busbar-free back contact cell assembly provided according to embodiments of the present disclosure;
Fig. 2 is a schematic diagram of modules of a busbar-free cell string provided according to embodiments of the present disclosure;
Fig. 3 is a schematic structural diagram of a busbar-free cell string provided according to embodiments of the present disclosure;
Fig. 4 is a schematic sectional diagram of the busbar-free cell string shown in Fig. 3 along a line IV-IV;
Fig. 5 is a schematic sectional diagram of a busbar-free cell assembly provided according to embodiments of the present disclosure;
Fig. 6 is another schematic structural diagram of a busbar-free cell string provided according to embodiments of the present disclosure;
Fig. 7 is another schematic flowchart of a preparation method for a busbar-free cell assembly provided according to embodiments of the present disclosure;
Fig. 8 is still another schematic flowchart of a preparation method for a busbar-free cell assembly provided according to embodiments of the present disclosure;
Fig. 9 is still another schematic flowchart of a preparation method for a busbar-free cell assembly provided according to embodiments of the present disclosure;
Fig. 10 is yet another schematic flowchart of a preparation method for a busbar-free cell assembly provided according to embodiments of the present disclosure; and
Fig. 11 is yet another schematic flowchart of a preparation method for a busbar-free cell assembly provided according to embodiments of the present disclosure.

Illustration of main elements and symbols:
Busbar-free back contact cell assembly 100, first cover plate 10, first adhesive film 20, busbar-free cell string 30, busbar-free back contact cell 31, back surface 311, positive fine grid 312, negative fine grid 313, positive solder ribbon 32, first positive solder ribbon 321, second positive solder ribbon 322, negative solder ribbon 33, first negative solder ribbon 331, second negative solder ribbon 332, pre-fixed film layer 34, first solder layer 35, second solder layer 36, first insulating layer 37, second insulating layer 38, second adhesive film 40, second cover plate 50, first dispensing adhesive 60, and second dispensing adhesive 70.

### Detailed Description of the Embodiments

In order to make objects, technical solutions and advantages of some embodiments of the present disclosure clearly understood, hereinafter, some embodiments of the present disclosure will be further described in detail in conjunction with the accompanying drawings and embodiments. Examples of the embodiments will be illustrated in the accompanying drawings, wherein throughout the description, same or similar reference numerals represent same or similar elements or elements with same or similar functions. The embodiments described below with reference to the accompanying drawings are illustrative, and are only intended to explain some embodiments of the present disclosure, and shall not be understood as limiting some embodiments of the present disclosure. In addition, it should be understood that the specific embodiments described herein are only used to explain some embodiments of the present disclosure, and are not intended to limit some embodiments of the present disclosure.

In the illustration of some embodiments of the present disclosure, it should be understood that orientation or positional relationships indicated by terms such as "upper", "lower", "back surface", "front surface", etc. are orientation or positional relationships based on those as shown in the drawings, and are only used to facilitate the illustration of some embodiments of the present disclosure and to simplify the illustration, rather than indicating or implying that an apparatus or element referred to must have a specific orientation, and be constructed and operated in the specific orientation, and therefore said terms cannot be understood as limiting some embodiments of the present disclosure.

In some embodiments of the present disclosure, unless explicitly specified or limited otherwise, a first feature being "above" or "below" a second feature may be the first feature and the second feature being in direct contact, or the first feature and the second feature being not in direct contact but being in contact with each other via another feature therebetween. Furthermore, a first feature being "over", "above", or "on" a second feature includes the first feature being directly above or obliquely above the second feature, or merely mean that the first feature having a horizontal height higher than that of the second feature. The first feature being "below", "beneath" or "under" the second feature includes the first feature being directly below or obliquely below the second feature, or merely mean that the first feature having a horizontal height lower than that of the second feature.

The following disclosure provides many different embodiments or examples for implementing different structures of some embodiments of the present disclosure. In order to simplify the disclosure of some embodiments of the present disclosure, specific examples of components and arrangements are described below. Of course, they are merely examples, and the purpose thereof is not intended to limit some embodiments of the present disclosure. In addition, some embodiments of the present disclosure may repeat reference numerals and/or reference letters in different examples, and such repetition is for the purpose of simplicity and clarity, which does not in itself indicate a relationship between the various embodiments and/or arrangements discussed. In addition, examples of various specific processes and materials are provided in some embodiments of the present disclosure, but a person of ordinary skill in the art can recognize applications of other processes and/or usage scenarios of other materials.

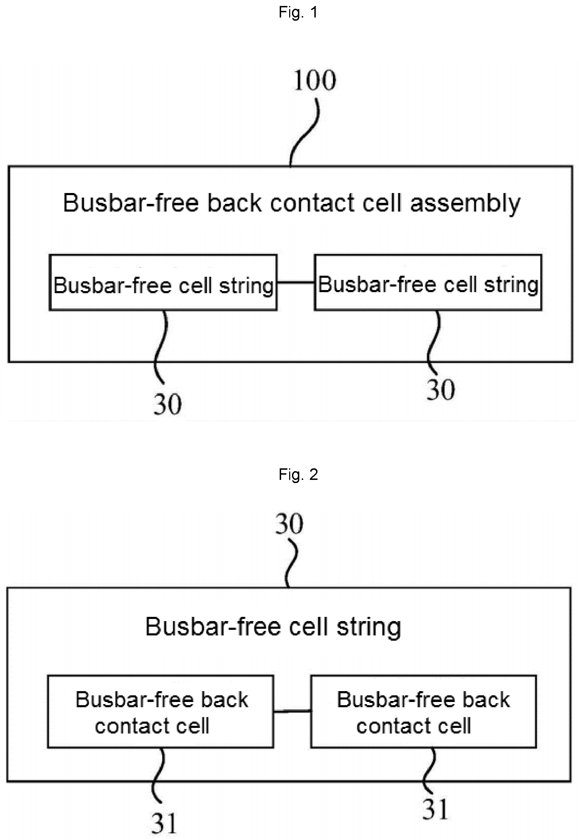

Please refer to Fig. 1 to Fig. 5, a busbar-free back contact cell assembly 100 according to embodiments of the present disclosure may include: a first cover plate 10, a first adhesive film 20, at least one busbar-free cell string 30, a second adhesive film 40 and a second cover plate 50 which are stacked in sequence.

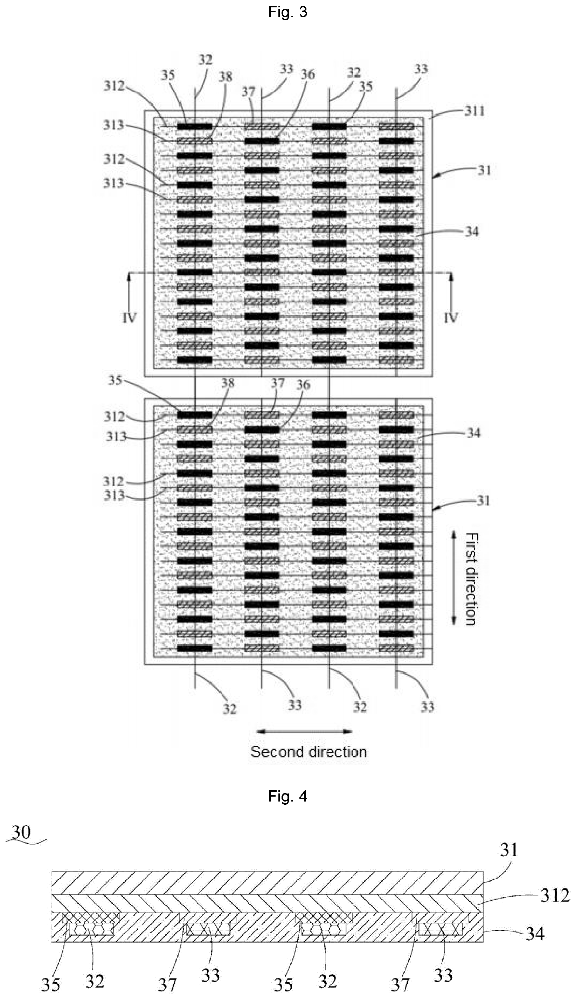

As shown in Fig. 3, the busbar-free cell string 30 may include several busbar-free back contact cells 31 (in Fig. 3, only two busbar-free back contact cells 31 are shown), several positive solder ribbons 32, several negative solder ribbons 33, and pre-fixed film layers 34. Back surfaces 311 of the busbar-free back contact cells 31 are provided with several positive fine grids 312 and several negative fine grids 313, and the several positive fine grids 312 and the several negative fine grids 313 are arranged alternately at intervals in sequence. Specifically, the positive fine grids 312 and the negative fine grids 313 may be arranged in parallel at intervals.

As shown in Fig. 3, in the busbar-free cell string 30, two adjacent busbar-free back contact cells 31 may be arranged at an interval. Of course, it will be appreciated that, in some embodiments, two adjacent busbar-free back contact cells 31 may also be connected to each other, or edge portions of two adjacent busbar-free back contact cells 31 overlap with each other in a lap joint manner, and the specific arrangement may be selected according to practical situations, and is not limited herein.

In the busbar-free cell string 30, the positive solder ribbons 32 may intersect with the positive fine grids 312 and are in conductive connection with the positive fine grids 312, and the negative solder ribbons 33 may intersect with the negative fine grids 313 and are in conductive connection with the negative fine grids 313. The several positive solder ribbons 32 and the several negative solder ribbons 33 are arranged alternately at intervals in sequence.

Specifically, as shown in Fig. 3, the positive fine grids 312 and the negative fine grids 313 may be alternately arranged at intervals in a first direction, and the positive solder ribbons 32 and the negative solder ribbons 33 may be alternately arranged in parallel at intervals in a second direction, and the first direction intersects with the second direction. As shown in Fig. 3, the first direction may be a longitudinal direction of the busbar-free back contact cells 31, and the second direction may be a transverse direction of the busbar-free back contact cells 31, and the two directions are perpendicular to each other.

As shown in Fig. 3 and Fig. 4, the pre-fixed film layers 34 are provided on the positive solder ribbons 32 and the negative solder ribbons 33, and the pre-fixed film layers 34 are fixedly connected to the back surfaces 311 of the busbar-free back contact cells 31, so as to fix the positive solder ribbons 32 and the negative solder ribbons 33 on the back surfaces 311. The second adhesive film 40 is covered on the pre-fixed film layers 34, and the flowability of the pre-fixed film layers 34 in an initial lamination process is lower than the flowability of the second adhesive film 40 in the initial lamination process.

It should be noted that, the "initial lamination process" refers to a stage before stable soldering is formed between the positive solder ribbons 32 and the positive fine grids and between the negative solder ribbons 33 and the negative fine grids 313 in a lamination and soldering process of the assembly.

In the busbar-free back contact cell assembly 100 in the embodiments of the present disclosure, the busbar-free cell string 30 is formed by the busbar-free back contact cells 31, the positive solder ribbons 32 are in conductive connection with the positive fine grids 312, and the negative solder ribbons 33 are in conductive connection with the negative solder ribbons 33, thereby achieving convergence and output of current. In addition, the positive solder ribbons 32 and the negative solder ribbons 33 are fixed on the busbar-free back contact cells 31 by the pre-fixed film layers 34. In this way, no busbar lines need to be provided on the back surfaces 311 of the busbar-free back contact cells 31, and there is no need to print a pad on the busbar, which can reduce the use of silver paste and reduce costs. Moreover, after the positive solder ribbons 32 and the negative solder ribbons 33 are laid, the positive solder ribbons 32 and the negative solder ribbons 33 are fixed on the back surfaces 311 of the busbar-free back contact cells 31 by using the pre-fixed film layers 34; and the flowability of the pre-fixed film layers 34 in the initial lamination process is lower than the flowability of the second adhesive film 40 in the initial lamination process. In this way, in the initial lamination process, the flowability of the pre-fixed film layers 34 is lower, which can effectively prevent deviation of the positive solder ribbons 32 and the negative solder ribbons 33 in the process of manufacturing the busbar-free back contact cell assembly 100. That is, in the initial lamination process, the pre-fixed film layers 34 can isolate a majority of flowing melt of the second adhesive film 40 after melting, to prevent the melt formed by the second adhesive film 40 from driving the positive solder ribbons 32 and the negative solder ribbons 33 to deviate, which improves the positioning and alignment precision of the positive solder ribbons 32 and the negative solder ribbons 33, thereby ensuring the yield. Moreover, compared with pre-fixing the negative solder ribbons 33 and the positive solder ribbons 32 by dispensing in the related art, fixing the negative solder ribbons 33 and the positive solder ribbons 32 by using the pre-fixed film layers 34 can effectively avoid cold solder joints and avoid EL defects. That is to say, fixing the solder ribbons by dispensing tends to lead to cold solder joints and cause EL defects, and the technical solutions of some embodiments of the present disclosure can avoid these problems.

Specifically, in the embodiments of the present disclosure, "the positive solder ribbons 32 intersect with the positive fine grids 312 and are in conductive connection with the positive fine grids 312, and the negative solder ribbons 33 intersect with the negative fine grids 313 and are in conductive connection with the negative fine grids 313" mean: in the extension direction of the positive solder ribbons 32, the positive solder ribbons 32 are only in conductive connection with the positive fine grids 312 and are insulated and isolated from the negative fine grids 313, and the negative solder ribbons 33 are only in conductive connection with the negative fine grids 313 and are insulated and isolated from the positive fine grids 312.

In some embodiments, the pre-fixed film layers 34 may be at least one of a PVB adhesive film, an EVA adhesive film, an EPE adhesive film, an EP adhesive film and a POE adhesive film, and the second adhesive film 40 may be at least one of a POE adhesive film, an EVA adhesive film, an EPE adhesive film, an EP adhesive film, a PE adhesive film and a PVB adhesive film, as long as the flowability of the pre-fixed film layers 34 in the initial lamination process can be made lower than the flowability of the second adhesive film 40 in the initial lamination process, which is not specifically limited herein.

Please refer to Fig. 3, in some embodiments, two adjacent busbar-free back contact cells 31 may be arranged at an interval; wherein the pre-fixed film layers 34 may cover only the busbar-free back contact cells 31, but do not cover a gap between the two busbar-free back contact cells 31. In this way, the use of the pre-fixed film layers 34 can be reduced while ensuring the fixing effect for the solder ribbons, thereby reducing costs.

Of course, in some embodiments, the pre-fixed film layers 34 may also cover both the busbar-free back contact cells 31 and the gap between two adjacent busbar-free back contact cells 31. In this way, when laying the pre-fixed film layers 34, a whole pre-fixed film layer can be directly covered on the busbar-free cell string 30, without the need of laying a pre-fixed film layer 34 separately on each busbar-free back contact cell 31, thereby reducing process costs.

Also, in some embodiments, the pre-fixed film layers 34 may at least cover the positive solder ribbons 32 and the negative solder ribbons 33. In this way, the pre-fixed film layers 34 may only cover the positive solder ribbons 32 and the negative solder ribbons 33, which may also reduce the use of the pre-fixed film layers 34 and reduce costs.

In some embodiments, the gram weight of the pre-fixed film layers 34 per square meter is 50 g-200 g.

Thus, this can prevent a too small gram weight of the pre-fixed film layers 34 from leading to a too thin thickness of the film layers and causing a high difficulty of the process (for example, a too large difficulty of adsorption laying), and this can also prevent a too large gram weight of the pre-fixed film layers 34 from causing a too high difficulty of the process during the film covering process (for example, excessive weight will increase the difficulty of adsorption laying, and can also easily lead to an uneven film layer), and this can also avoid too high costs. That is to say, by setting the gram weight of the pre-fixed film layers 34 per square meter within such a range of 50 g-200 g, while ensuring the fixing effect for the solder ribbons, a too large process difficulty is avoided and too high costs are avoided.

Specifically, in such embodiments, the gram weight of the pre-fixed film layers 34 per square meter may, for example, be 50 g, 60 g, 70 g, 80 g, 90 g, 100 g, 110 g, 120 g, 130 g, 140 g, 150 g, 160 g, 170 g, 180 g, 190 g, 200 g, or any value between 50 g and 200 g; wherein the gram weight of the pre-fixed film layers 34 per square meter is preferably 100 g.

Please refer to Fig. 3 and Fig. 4, in some embodiments, first solder layers 35 are provided at positions on the positive fine grids 312 in contact with the positive solder ribbons 32, and the positive solder ribbons 32 are connected to the first solder layers 35; and second solder layers 36 are provided at positions on the negative fine grids 313 in contact with the negative solder ribbons 33, and the negative solder ribbons 33 are connected to the second solder layers 36.

In this way, in the manufacturing process, pre-fixed contact between the positive solder ribbons 32 and the first solder layers 35 and between the negative solder ribbons 33 and the second solder layers 36 may be first implemented by the pre-fixed film layers 34; and then in the lamination process, the positive solder ribbons 32 and the first solder layers 35 are soldered together and the negative solder ribbons 33 and the second solder layers 36 are soldered together, thereby forming firm connections.

Specifically, as shown in Fig. 3, in such embodiments, in the extension direction of the positive solder ribbons 32, the first solder layer 35 is provided at a position on each positive fine grid 312 intersecting with a corresponding positive solder ribbon 32; and in the extension direction of the negative solder ribbons 33, the second solder layer 36 is provided at a position on each negative fine grid 313 intersecting with a corresponding negative solder ribbon 33.

In the embodiments of the present disclosure, both the first solder layers 35 and the second solder layers 36 may be made of a solder paste. In this way, the soldering temperature of the solder paste is low, the soldering between the solder ribbons and the solder paste can be achieved by low-temperature soldering of the solder paste, and the soldering does not need to be performed at a high temperature, which can effectively prevent the cell string from becoming severely warped after soldering, improve the yield, and reduce the manufacturing difficulty.

In such embodiments, when manufacturing the busbar-free back contact cell assembly 100, a solder paste may be printed at positions where the positive fine grids 312 contact the positive solder ribbons 32 and at positions where the negative fine grids 313 contact the negative solder ribbons 33, and a drying and curing treatment is not performed, and then the positive solder ribbons 32 and the negative solder ribbons 33 are laid, and then a soldering treatment is performed in the lamination process. In this way, uncured solder paste may be better connected to the positive solder ribbons 32 and the negative solder ribbons 33 in the lamination and soldering process, so as to avoid cold solder joints and separation of the solder ribbons. Of course, in some embodiments, when manufacturing the busbar-free back contact cell assembly, first, the solder paste may also be printed at positions where the positive fine grids 312 contact the positive solder ribbons 32 and at positions where the negative fine grids 313 contact the negative solder ribbons 33, and then a drying treatment is performed, which is not specifically limited herein.

In some embodiments, the positive solder ribbons 32 may completely cover the first solder layers 35, and the negative solder ribbons 33 may completely cover the second solder layers 36. In this way, when the first solder layers 35 and the second solder layers 36 are manufactured by using an uncured solder paste and are not dried and cured, completely covering the uncured solder paste by the positive solder ribbons 32 and the negative solder ribbons 33 can effectively prevent the solder paste from splashing.

Please continue to refer to Fig. 3, in some embodiments, first insulating layers 37 are provided at positions on the positive fine grids 312 intersecting with the negative solder ribbons 33, and the negative solder ribbons 33 are insulated and isolated from the positive fine grids 312 by the first insulating layers 37. Second insulating layers 38 are provided at positions on the negative fine grids 313 intersecting with the positive solder ribbons 32, and the positive solder ribbons 32 are insulated and isolated from the positive fine grids 312 by the second insulating layers 38.

In this way, the arrangement of the first insulating layers 37 can prevent the negative solder ribbons 33 from contacting the positive fine grids 312, and the arrangement of the second insulating layers 38 can prevent the positive solder ribbons 32 from contacting the negative fine grids 313.

Specifically, in such embodiments, the first insulating layers 37 and the second insulating layers 38 may both be insulating adhesive layers. As shown in Fig. 3, for each positive solder ribbon 32, in the extension direction of the positive solder ribbons 32, several second insulating layers 38 and several first solder layers 35 are arranged alternately; and for each negative solder ribbon 33, in the extension direction of the negative solder ribbons 33, several first insulating layers 37 and several second solder layers 36 are arranged alternately.

Of course, in some embodiments, the positive fine grids 312 may also be disconnected at positions intersecting with the negative solder ribbons 33, and the negative fine grids 313 may also be disconnected at positions intersecting with the positive solder ribbons 32. In this way, the disconnection design of the positive fine grids 312 and the negative fine grids 313 can prevent the positive solder ribbons 32 from contacting the negative fine grids 313, and prevent the negative solder ribbons 33 from contacting the positive fine grids 312, thereby reducing the use of insulating adhesive.

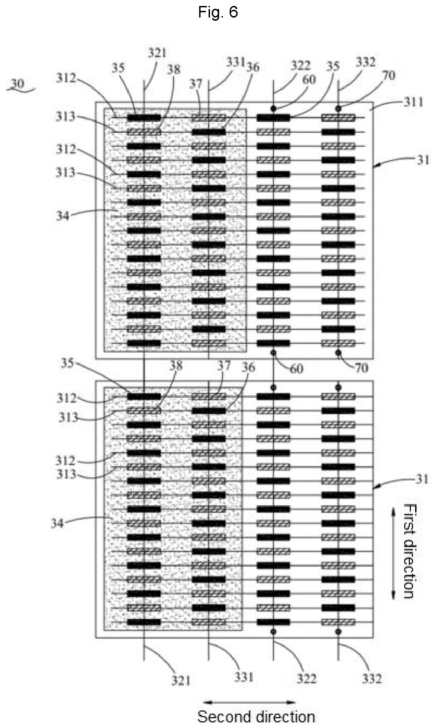

Please refer to Fig. 6, in some embodiments, the several positive solder ribbons 32 may include several first positive solder ribbons 321 and several second positive solder ribbons 322, the pre-fixed film layers 34 are provided on the first positive solder ribbons 321 to fix the first positive solder ribbons 321 on the back surfaces 311, and the second positive solder ribbons 322 are fixed on the back surfaces 311 by a first dispensing adhesive 60.

In addition, please continue to refer to Fig. 6, in some embodiments, the several negative solder ribbons 33 include several first negative solder ribbons 331 and several second negative solder ribbons 332, the pre-fixed film layers 34 are provided on the first negative solder ribbons 331 to fix the first negative solder ribbons 331 on the back surfaces 311, and the second negative solder ribbons 332 are fixed on the back surfaces 311 by a second dispensing adhesive 70.

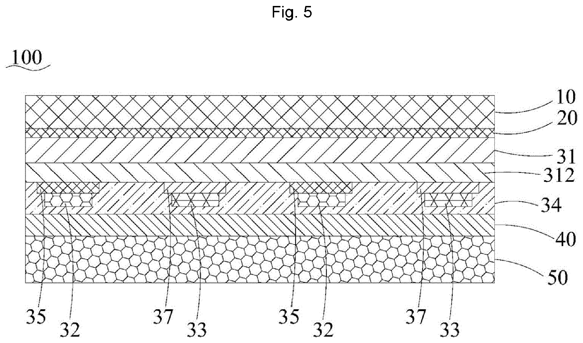

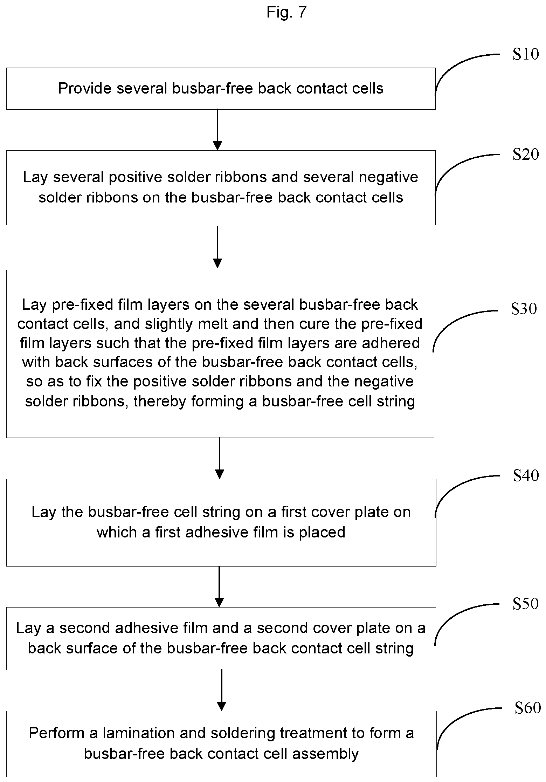

Please refer to Fig. 5 and Fig. 7, some embodiments of the present disclosure further provide a preparation method for a busbar-free back contact cell assembly 100. The preparation method may include the following steps:
S10: several busbar-free back contact cells 31 are provided;
as shown in Fig. 3, back surfaces 311 of the busbar-free back contact cells 31 are provided with several positive fine grids 312 and several negative fine grids 313, and the several positive fine grids 312 and the several negative fine grids 313 are arranged alternately at intervals in sequence; and two adjacent busbar-free back contact cells 31 may be arranged at an interval, and may also be connected to each other, or edge portions of two adjacent busbar-free back contact cells 31 overlap with each other in a lap joint manner.
S20: several positive solder ribbons 32 and several negative solder ribbons 33 are laid on the busbar-free back contact cells 31;
wherein as shown in Fig. 3, the positive solder ribbons 32 intersect with the positive fine grids 312 and are in conductive connection with the positive fine grids 312, and the negative solder ribbons 33 intersect with the negative fine grids 313 and are in conductive connection with the negative fine grids 313;
S30: pre-fixed film layers 34 are laid on the several busbar-free back contact cells 31, and the pre-fixed film layers 34 are slightly molten and then cured to be adhered with the back surfaces 311 of the busbar-free back contact cells 31, so as to fix the positive solder ribbons 32 and the negative solder ribbons 33, thereby forming a busbar-free cell string 30;
S40: the busbar-free cell string 30 is laid on a first cover plate 10 on which a first adhesive film 20 is placed;
wherein the back surfaces 311 of the busbar-free back contact cells 31 face away from the first adhesive film 20;
S50: a second adhesive film 40 and a second cover plate 50 are laid on a back surface of the busbar-free cell string 30; and
S60: a lamination and soldering treatment is performed to form the busbar-free back contact cell assembly 100; wherein the flowability of the pre-fixed film layers 34 in an initial lamination process is lower than the flowability of the second adhesive film 40 in the initial lamination process.

It should be noted that, the "initial lamination process" refers to a stage before stable soldering is formed between the positive solder ribbons 32 and the positive fine grids and between the negative solder ribbons 33 and the negative fine grids 313 in the lamination and soldering process of the assembly.

In this way, after the positive solder ribbons 32 and the negative solder ribbons 33 are laid, the positive solder ribbons 32 and the negative solder ribbons 33 are pre-fixed on the back surfaces 311 of the busbar-free back contact cells 31 by laying the pre-fixed film layers 34 and making the pre-fixed film layers 34 slightly molten and then cured; and the flowability of the pre-fixed film layers 34 in the initial lamination process is lower than the flowability of the second adhesive film 40 in the initial lamination process. The existence of the pre-fixed film layers 34 can prevent a melt formed after melting of the second adhesive film 40 during lamination from driving the solder ribbons to move, thereby effectively avoiding the deviation of the positive solder ribbons 32 and the negative solder ribbons 33 in the process of manufacturing the busbar-free back contact cell assembly 100, which can improve the positioning and alignment precision of the positive solder ribbons 32 and the negative solder ribbons 33, thereby ensuring the yield.

Specifically, in the embodiments of the present disclosure, the pre-fixed film layers 34 may preferably directly use film layers having flowability lower than that of the second adhesive film 40; for example, the pre-fixed film layers 34 may use a PVB adhesive film, and the second adhesive film 40 may use film layers such as an EVA adhesive film and a POE adhesive film. Of course, in some embodiments, the film layer material of the pre-fixed film layers 34 may also be the same as the film layer material of the second adhesive film 40, for example, both of them may use a PVB film layer. In such a case, when laying the pre-fixed film layers 34, the film layers are heated, slightly molten and then cured so as to be adhered together with the back surfaces 311, and thus, since the pre-fixed film layers 34 havev been slightly molten and cured once, then the flowability of the pre-fixed film layers 34 is also lower than that of the second adhesive film 40 in a subsequent initial lamination stage.

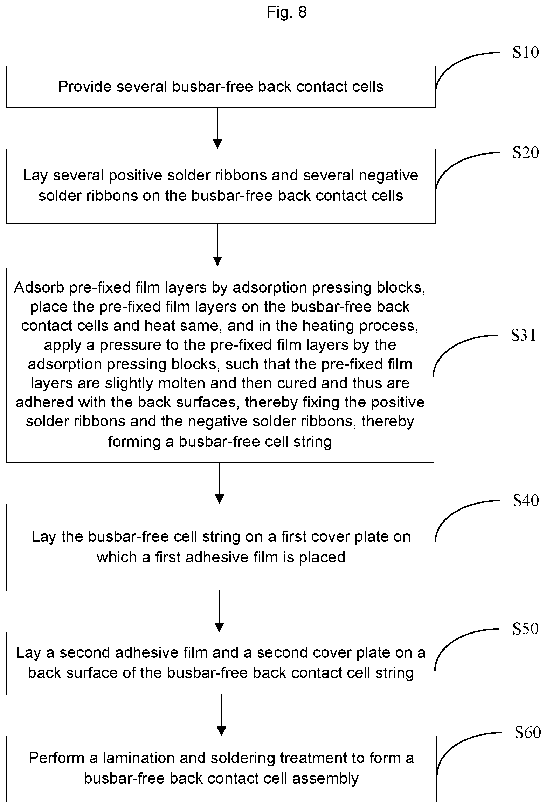

Please refer to Fig. 8, in some embodiments, step S30 may include the following step:
S31: the pre-fixed film layers 34 are adsorbed by adsorption pressing blocks, the pre-fixed film layers 34 are placed on the busbar-free back contact cells 31 and heated, and in the heating process, a pressure is applied to the pre-fixed film layers 34 by the adsorption pressing blocks, such that the pre-fixed film layers 34 are slightly molten and then cured and thus are adhered with the back surfaces 311, thereby fixing the positive solder ribbons 32 and the negative solder ribbons 33, so as to form the busbar-free cell string 30.

In this way, the pre-fixed film layers 34 can be stably placed on the busbar-free back contact cells 31 by adsorption and pressure applying of the adsorption pressing blocks, such that the pre-fixed film layers 34 can pre-fix the positive solder ribbons 32 and the negative solder ribbons 33 on the back surfaces of the busbar-free back contact cells 31.

Specifically, the adsorption pressing blocks may be pressing blocks having several adsorption holes, are commonly known as a film palm, and can adsorb the film layers and place and press the film layers on a cell sheet.

Further, in such embodiments, when the pre-fixed film layers 34 are laid, the temperature is maintained in a temperature range of 50°C-150°C, such that the pre-fixed film layers 34 are slightly molten.

Thus, this can avoid the situation that the adhesive film cannot be molten or the adhesive film needs to be molten for a too long time period due to a too low temperature when laying the pre-fixed film layers 34, and this can also prevent the pre-fixed film layers 34 from wrinkling due to a too high temperature and prevent the cell sheet from warping due to a too high temperature, thereby increasing the process difficulty.

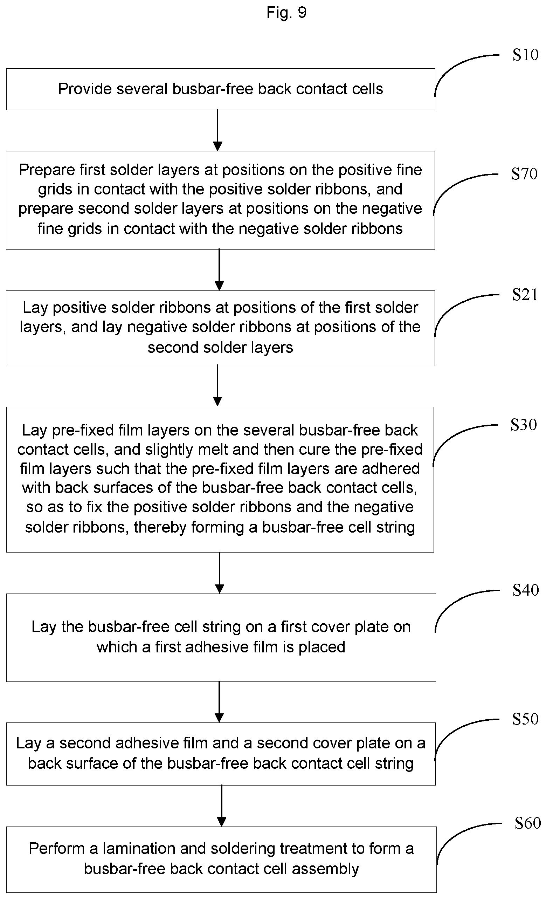

Please refer to Fig. 9, in some embodiments, before step S20, the preparation method may further include the following step:
S70: first solder layers 35 are prepared at positions on the positive fine grids 312 in contact with the positive solder ribbons 32, and second solder layers 36 are prepared at positions on the negative fine grids 313 in contact with the negative solder ribbons 33; and
step S20 includes the following step:
   S21: positive solder ribbons 32 are laid at positions of the first solder layers 35, and negative solder ribbons 33 are laid at positions of the second solder layers 36.

Specifically, in such embodiments, the first solder layers 35 and the second solder layers 36 may both be formed by printing a solder paste; and in some embodiments, the first solder layers 35 and the second solder layers 36 are both formed by printing a solder paste, and then drying and curing same.

In some other embodiments, the first solder layers 35 and the second solder layers 36 are both formed by printing a solder paste without drying and curing, and when the solder paste is not cured and dried, the connection performance between the solder ribbons and the solder paste can be ensured in a subsequent soldering process.

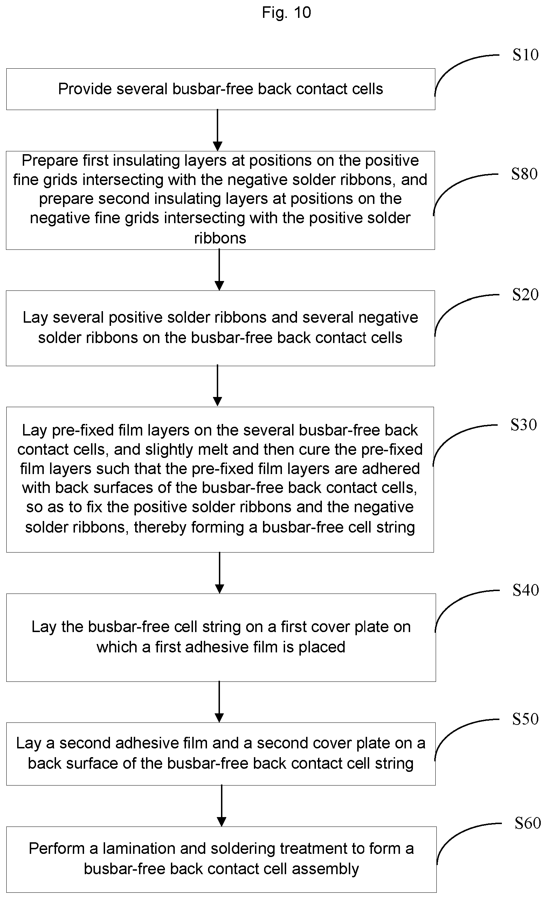

Please refer to Fig. 10, in some embodiments, before step S20, the preparation method may further include the following step:
S80: first insulating layers 37 are prepared at positions on the positive fine grids 312 intersecting with the negative solder ribbons 33, and second insulating layers 38 are prepared at positions on the negative fine grids 313 intersecting with the positive solder ribbons.

In this way, the arrangement of the first insulating layers 37 can prevent the negative solder ribbons 33 from contacting the positive fine grids 312, and the arrangement of the second insulating layers 38 can prevent the positive solder ribbons 32 from contacting the negative fine grids 313.

Specifically, in such embodiments, the first insulating layers 37 and the second insulating layers 38 may both be insulating adhesive layers. In the manufacturing process, by printing, fine grids with the same polarity may be printed with an insulating adhesive according to the covering positions of the solder ribbons, and after the printing is completed, the insulating adhesive is heated by an oven or heated and cured by a curing furnace so as to form the first insulating layers 37 and the second insulating layers 38, and the hardness of the insulating adhesive after heating is greater than 5H. It should be understood that, in some embodiments of the present disclosure, the sequence of S70 and S80 is not limited, and S70 may be performed first, and also S80 may be performed first, or both the two may be performed simultaneously, which is not specifically limited herein.

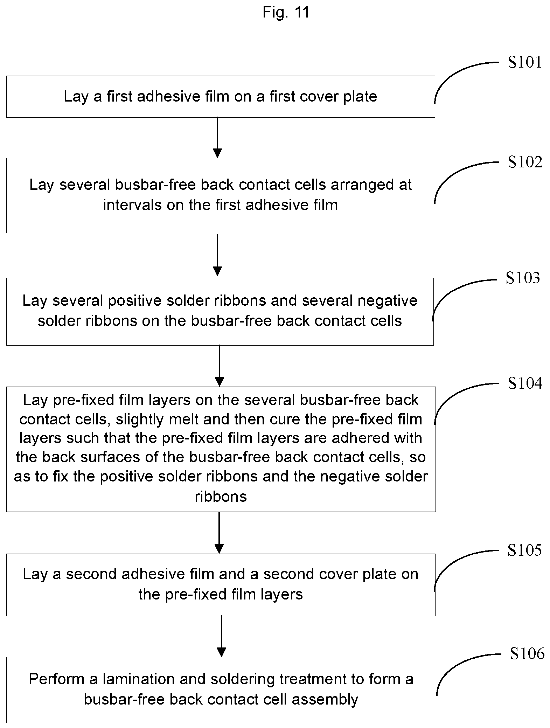

Please refer to Fig. 11, some embodiments of the present disclosure further provide another preparation method for a busbar-free back contact cell assembly 100. The method includes the following steps:
S101: a first adhesive film 20 is laid on a first cover plate 10;
S102: several busbar-free back contact cells 31 arranged at intervals are laid on the first adhesive film 20;
wherein back surfaces 311 of the busbar-free back contact cells 31 are provided with several positive fine grids 312 and several negative fine grids 313, and the several positive fine grids 312 and the several negative fine grids 313 are arranged alternately at intervals in sequence, and the back surfaces 311 of the busbar-free back contact cells 31 face away from the first adhesive film 20;
S103: several positive solder ribbons 32 and several negative solder ribbons 33 are laid on the busbar-free back contact cells 31; wherein the positive solder ribbons 32 intersect with the positive fine grids 312 and are in conductive connection with the positive fine grids 312, and the negative solder ribbons 33 intersect with the negative fine grids 313 and are in conductive connection with the negative fine grids 313;
S104: pre-fixed film layers 34 are laid on the several busbar-free back contact cells 31, and the pre-fixed film layers 34 are slightly molten and then cured so as to be adhered with the back surfaces 311 of the busbar-free back contact cells 31, so as to fix the positive solder ribbons 32 and the negative solder ribbons 33;
S105: a second adhesive film 40 and a second cover plate 50 are laid on the pre-fixed film layers 34; and
S106: a lamination and soldering treatment is performed to form the busbar-free back contact cell assembly 100;
wherein the flowability of the pre-fixed film layers 34 in an initial lamination process is lower than the flowability of the second adhesive film 40 in the initial lamination process.

This preparation method differs from the preparation method in the embodiments of the preceding text in that: in the preparation method of the preceding text, the busbar-free cell string 30 provided with pre-fixed film layers 34 is first prepared, then at least one busbar-free cell string 30 is placed on the first cover plate 10 provided with the first adhesive film 20, then the second adhesive film 40 and the second cover plate 50 are laid, and then lamination and soldering are performed. However, in the preparation method of the present embodiment, first the busbar-free back contact cells 31 are laid on the first adhesive film 20, then the positive solder ribbons 32 and the negative solder ribbons 33 are placed, then the pre-fixed film layers 34 are laid and the pre-fixed film layers 34 are slightly molten and then cured so as to pre-fix the positive solder ribbons 32 and the negative solder ribbons 33 on the busbar-free back contact cells 31, and then the second adhesive film 40 and the second cover plate 50 are laid, and finally lamination and soldering are performed.

It should be understood that, in such embodiments, the method for laying the pre-fixed film layers 34 is the same as that in the embodiments as described above; moreover, in this embodiment, the first solder layers 35, the second solder layers 36, the first insulating layers 37, and the second insulating layers 38 may also be manufactured using steps S70 and S80 in the embodiments as described above, which will not be elaborated herein.

In the illustration of the description, the illustration of reference terms "some embodiments", "illustrative embodiments", "examples", "specific examples", or "some examples" means that specific features, structures, materials, or characteristics described in connection with the embodiments or examples are included in at least one embodiment or example of some embodiments of the present disclosure. In the description, the illustrative expressions of the described terms do not necessarily refer to the same embodiment or example. Furthermore, the specific features, structures, materials, or characteristics described may be combined in any suitable manner in one or more embodiments or examples.

In addition, the content above merely relates to preferred embodiments of the present disclosure, and is not intended to limit the present disclosure. Any modifications, equivalent replacements, improvements and the like made within the spirit and principle of the present disclosure shall all fall within the scope of protection of the present disclosure.

## Claims

1. A busbar-free back contact cell assembly, the busbar-free back contact cell assembly comprising a first cover plate, a first adhesive film, at least one busbar-free cell string, a second adhesive film and a second cover plate which are stacked in sequence; wherein the busbar-free cell string comprises:
several busbar-free back contact cells, wherein back surfaces of the busbar-free back contact cells are provided with several positive fine grids and several negative fine grids, and the several positive fine grids and the several negative fine grids are arranged alternately at intervals in sequence;
several positive solder ribbons and several negative solder ribbons, wherein the positive solder ribbons intersect with the positive fine grids and are in conductive connection with the positive fine grids, and the negative solder ribbons intersect with the negative fine grids and are in conductive connection with the negative fine grids; and
pre-fixed film layers, which are provided on the positive solder ribbons and the negative solder ribbons, wherein the pre-fixed film layers are fixedly connected to the back surfaces, so as to fix the positive solder ribbons and the negative solder ribbons on the back surfaces;
wherein the second adhesive film is covered on the pre-fixed film layers, and a flowability of the pre-fixed film layers in an initial lamination process is lower than a flowability of the second adhesive film in the initial lamination process.

2. The busbar-free back contact cell assembly according to claim 1, wherein a gram weight of the pre-fixed film layers per square meter is 50 g-200 g.

3. The busbar-free back contact cell assembly according to claim 1, wherein first solder layers are provided at positions on the positive fine grids in contact with the positive solder ribbons, and the positive solder ribbons are connected to the first solder layers; and second solder layers are provided at positions on the negative fine grids in contact with the negative solder ribbons, and the negative solder ribbons are connected to the second solder layers.

4. The busbar-free back contact cell assembly according to claim 3, wherein both the first solder layers and the second solder layers are made of a solder paste.

5. The busbar-free back contact cell assembly according to claim 4, wherein the positive solder ribbons completely cover the first solder layers, and the negative solder ribbons completely cover the second solder layers.

6. The busbar-free back contact cell assembly according to claim 1, wherein first insulating layers are provided at positions on the positive fine grids intersecting with the negative solder ribbons, and the negative solder ribbons are insulated and isolated from the positive fine grids by the first insulating layers; and
second insulating layers are provided at positions on the negative fine grids intersecting with the positive solder ribbons, and the positive solder ribbons are insulated and isolated from the positive fine grids by the second insulating layers.

7. The busbar-free back contact cell assembly according to claim 1, wherein the positive fine grids are disconnected at positions intersecting with the negative solder ribbons, and the negative fine grids are disconnected at positions intersecting with the positive solder ribbons.

8. The busbar-free back contact cell assembly according to claim 1, wherein the pre-fixed film layers comprise at least one of a PVB adhesive film, an EVA adhesive film, an EPE adhesive film, an EP adhesive film and a POE adhesive film, and the second adhesive film comprises at least one of a POE adhesive film, an EVA adhesive film, an EPE adhesive film, an EP adhesive film, a PE adhesive film and a PVB adhesive film.

9. The busbar-free back contact cell assembly according to claim 1, wherein two adjacent busbar-free back contact cells are arranged at an interval;
wherein the pre-fixed film layers cover the busbar-free back contact cells; or
the pre-fixed film layers cover both the busbar-free back contact cells and a gap between the two adjacent busbar-free back contact cells; or
the pre-fixed film layers at least cover the positive solder ribbons and the negative solder ribbons.

10. The busbar-free back contact cell assembly according to claim 1, wherein the several positive solder ribbons comprise several first positive solder ribbons and several second positive solder ribbons, the pre-fixed film layers are provided on the first positive solder ribbons to fix the first positive solder ribbons on the back surfaces, and the second positive solder ribbons are fixed on the back surfaces by a first dispensing adhesive.

11. The busbar-free back contact cell assembly according to claim 1, wherein the several negative solder ribbons comprise first negative solder ribbons and second negative solder ribbons, the pre-fixed film layers are provided on the first negative solder ribbons to fix the first negative solder ribbons on the back surfaces, and the second negative solder ribbons are fixed on the back surfaces by a second dispensing adhesive.

12. A preparation method for a busbar-free back contact cell assembly, comprising:
providing several busbar-free back contact cells, wherein back surfaces of the busbar-free back contact cells are provided with several positive fine grids and several negative fine grids, and the several positive fine grids and the several negative fine grids are arranged alternately at intervals in sequence;
laying several positive solder ribbons and several negative solder ribbons on the busbar-free back contact cells, wherein the positive solder ribbons intersect with the positive fine grids and are in conductive connection with the positive fine grids, and the negative solder ribbons intersect with the negative fine grids and are in conductive connection with the negative fine grids;
laying pre-fixed film layers on the several busbar-free back contact cells, and slightly melting and then curing the pre-fixed film layers such that the pre-fixed film layers are adhered with the back surfaces of the busbar-free back contact cells, so as to fix the positive solder ribbons and the negative solder ribbons, thereby forming a busbar-free cell string;
laying the busbar-free cell string on a first cover plate on which a first adhesive film is placed, wherein the back surfaces of the busbar-free back contact cells face away from the first adhesive film;
laying a second adhesive film and a second cover plate on a back surface of the busbar-free back contact cell string; and
performing a lamination and soldering treatment to form the busbar-free back contact cell assembly, wherein a flowability of the pre-fixed film layers in an initial lamination process is lower than a flowability of the second adhesive film in the initial lamination process.

13. The preparation method for a busbar-free back contact cell assembly according to claim 12, wherein laying the pre-fixed film layers on the several busbar-free back contact cells, and slightly melting the pre-fixed film layers such that the pre-fixed film layers are adhered with the back surfaces of the busbar-free back contact cells, so as to fix the positive solder ribbons and the negative solder ribbons, comprises:
adsorbing the pre-fixed film layers by adsorption pressing blocks, placing the pre-fixed film layers on the busbar-free back contact cells and heating the pre-fixed film layers, and in the heating process, applying a pressure to the pre-fixed film layers by the adsorption pressing blocks, such that the pre-fixed film layers are slightly molten and then cured and thus are adhered with the back surfaces, thereby fixing the positive solder ribbons and the negative solder ribbons.

14. The preparation method for a busbar-free back contact cell assembly according to claim 13, wherein when the pre-fixed film layers are laid, a temperature is maintained in a temperature range of 50°C-150°C, such that the pre-fixed film layers are slightly molten.

15. The preparation method for a busbar-free back contact cell assembly according to claim 12, wherein before laying the several positive solder ribbons and the several negative solder ribbons on the busbar-free back contact cells, the preparation method further comprises:
preparing first solder layers at positions on the positive fine grids in contact with the positive solder ribbons, and preparing second solder layers at positions on the negative fine grids in contact with the negative solder ribbons; and
laying the several positive solder ribbons and the several negative solder ribbons on the busbar-free back contact cells, comprises:
laying the positive solder ribbons at positions of the first solder layers, and laying the negative solder ribbons at positions of the second solder layers.

16. The preparation method for a busbar-free back contact cell assembly according to claim 15, wherein the first solder layers and the second solder layers are both formed by printing a solder paste and then drying and curing same, or are formed without drying and curing.

17. The preparation method for a busbar-free back contact cell assembly according to claim 12, wherein before laying the several positive solder ribbons and the several negative solder ribbons on the busbar-free back contact cells, the preparation method further comprises:
preparing first insulating layers at positions on the positive fine grids intersecting with the negative solder ribbons, and preparing second insulating layers at positions on the negative fine grids intersecting with the positive solder ribbons.

18. A preparation method for a busbar-free back contact cell assembly, comprising:
laying a first adhesive film on a first cover plate;
laying several busbar-free back contact cells arranged at intervals on the first adhesive film, wherein back surfaces of the busbar-free back contact cells are provided with several positive fine grids and several negative fine grids, and the several positive fine grids and the several negative fine grids are arranged alternately at intervals in sequence, and the back surfaces of the busbar-free back contact cells face away from the first adhesive film;
laying several positive solder ribbons and several negative solder ribbons on the busbar-free back contact cells, wherein the positive solder ribbons intersect with the positive fine grids and are in conductive connection with the positive fine grids, and the negative solder ribbons intersect with the negative fine grids and are in conductive connection with the negative fine grids;
laying pre-fixed film layers on the several busbar-free back contact cells, slightly melting and then curing the pre-fixed film layers such that the pre-fixed film layers are adhered with the back surfaces of the busbar-free back contact cells, so as to fix the positive solder ribbons and the negative solder ribbons;
laying a second adhesive film and a second cover plate on the pre-fixed film layers; and
performing a lamination and soldering treatment to form the busbar-free back contact cell assembly, wherein a flowability of the pre-fixed film layers in an initial lamination process is lower than a flowability of the second adhesive film in the initial lamination process.

19. The preparation method for a busbar-free back contact cell assembly according to claim 18, wherein laying the pre-fixed film layers on the several busbar-free back contact cells, and slightly melting the pre-fixed film layers such that the pre-fixed film layers are adhered with the back surfaces of the busbar-free back contact cells, so as to fix the positive solder ribbons and the negative solder ribbons, comprises:
adsorbing the pre-fixed film layers by adsorption pressing blocks, placing the pre-fixed film layers on the busbar-free back contact cells and heating the pre-fixed film layers, and in the heating process, applying a pressure to the pre-fixed film layers by the adsorption pressing blocks, such that the pre-fixed film layers are slightly molten and then cured and thus are adhered with the back surfaces, thereby fixing the positive solder ribbons and the negative solder ribbons.

20. The preparation method for a busbar-free back contact cell assembly according to claim 18, wherein before laying the several positive solder ribbons and the several negative solder ribbons on the busbar-free back contact cells, the preparation method further comprises:
preparing first solder layers at positions on the positive fine grids in contact with the positive solder ribbons, and preparing second solder layers at positions on the negative fine grids in contact with the negative solder ribbons; and
laying the several positive solder ribbons and the several negative solder ribbons on the busbar-free back contact cells comprises:
laying the positive solder ribbons at positions of the first solder layers, and laying the negative solder ribbons at positions of the second solder layers.
